Europäisches Patentamt

(19) European Patent Office   (11) Publication number: **0 022 580**

Office européen des brevets   **A1**

(12) **EUROPEAN PATENT APPLICATION**

(21) Application number: **80104114.6**

(22) Date of filing: **15.07.80**

(51) Int. Cl.³: **H 01 F 41/14**

(30) Priority: **17.07.79  US 58297**

(71) Applicant: **Western Electric Company, Incorporated, P.O. Box 901, Princeton New Jersey 08540 (US)**

(43) Date of publication of application: **21.01.81 Bulletin 81/3**

(72) Inventor: **Roman, Bernard John, 5 Webster Avenue, Summit New Jersey 07901 (US)**

(74) Representative: **Blumbach Weser Bergen Kramer Zwirner Hoffmann Patentanwälte, Radeckestrasse 43, D-8000 München 60 (DE)**

(84) Designated Contracting States: **BE DE FR GB IT NL SE**

(54) Advantageous fabrication technique for devices relying on magnetic properties.

㊼ A process for producing devices, which rely on magnetic properties, especially useful for the fabrication of magnetic bubble devices, and which have planar geometries, includes depositing a material (17) such as a photolithographic resist in a desired pattern on an electrically insulating layer (16), e.g., SiO₂, etching, at least partially, the exposed areas of the insulating material, depositing an appropriate metal (22) onto the etched regions (21) in a thickness such that an essentially planar geometry is formed by the surface of the metal layer in the exposed portions of the electrically insulating layer and by the surface of the delineated portions of the insulating layer, and then lifting off the initial resist deposition.

EP 0 022 580 A1

Background of the Invention

1. Field of the Invention

This invention relates to devices relying on magnetic properties and, more particularly, to the fabrication of these devices.

2. Art Background

Devices relying on magnetic properties often require the deposition of a metal film during their fabrication. For example, in the case of magnetic bubble devices, an aluminum alloy is deposited on a silicon dioxide layer that, in turn, overlays the magnetic garnet epilayer. These metallic films are often patterned to produce a desired result in a localized area of the device. In the example of magnetic bubble devices, the aluminum alloy does not cover the entire silicon dioxide layer, but is confined to areas where control functions are performed, e.g., the metal film is patterned to induce bubble nucleation, replication or transfer in a particular area of the magnetic garnet film at a given instant in time.

Since the metallic films utilized are not continuous, but are localized in particular areas of the devices, subsequent deposited layers will not fill in the steps produced by this localization. Thus, continuing the example of magnetic bubble devices, if another silicon dioxide layer is deposited over the aluminum alloy, this silicon dioxide layer will not be planar, but will have depressions in areas where the underlying aluminum alloy is absent.

This non-planar structure, although usually unimportant in semiconductor devices, often becomes significant in devices which rely on magnetic properties. Since magnetization is a three dimensional effect, a film that is not planar experiences magnetic gradients through its cross-section. For example, in the case of magnetic

2.   **0022580**

bubble devices if a permalloy alloy is deposited on a stepped silicon dioxide film, this permalloy alloy is similarly non-planar. When magnetic fields are introduced to operate the device, various areas of the permalloy strip experience spurious magnetic effects. This results in a degree of device unreliability. (See, for example, W. Strauss, Journal of Applied Physics, 49 1897 (1978).)

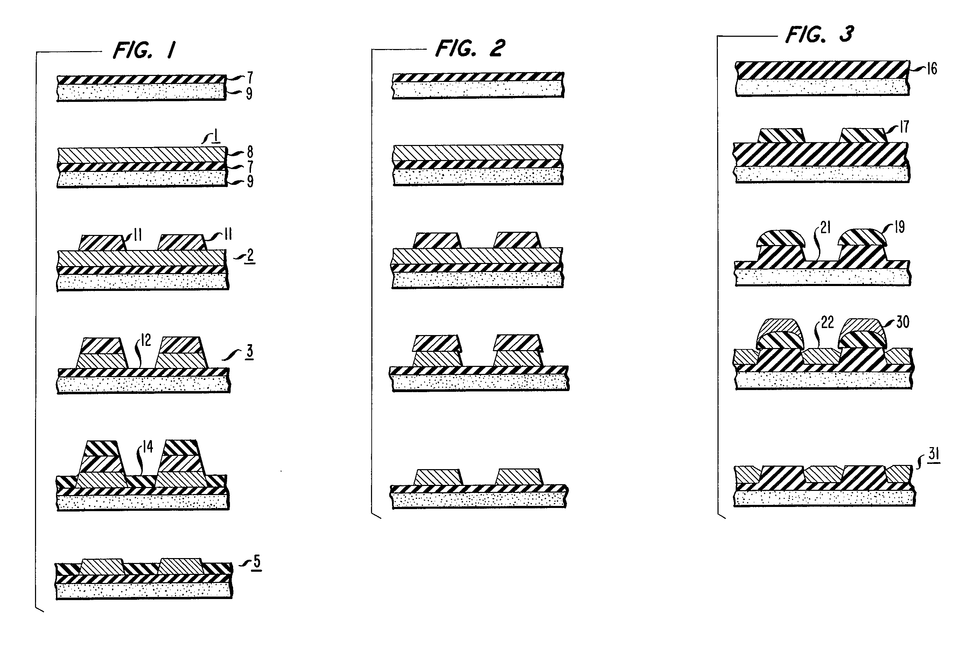

Various fabrication schemes have been developed to produce a planar geometry in devices relying on magnetic properties. For example, Yamagishi has described (Third U.S.A.-Japan Computer Conference, October 10th through 12th, 1978, Session 20-3-1) a method of forming a planar geometry on an underlying substrate. This process is schematically illustrated in FIG. 1. The first step, 1 in FIG. 1, includes the deposition of an aluminum alloy, 8, upon the substrate, which is a silicon oxide, 7, coated magnetic epilayer, 9. In the second step, 2, a resist material, 11, is deposited on the alloy which in the third step, 3, is etched in the exposed areas, 12. A layer of silicon monoxide, 14, is then deposited on the substrate thus covering both the resist and the exposed areas of the aluminum alloy. The resist is then lifted off and the planar geometry, 5, is obtained.

A comparison of FIG. 1 which shows the Yamagishi technique and FIG. 2 which shows the steps required in the conventional non-planar production method demonstrates that an additional step involving the deposition of a silicon monoxide layer is required. Obviously, this additional step leads to associated production difficulties and costs. Other proposed methods for fabricating devices with planar geometries require even more processing steps with their associated costs and difficulties. (See, for example, Rose, IEEE Transactions on Magnetics, MAG-12, (6), 618, (1976), and Reekstin, et al, IEEE Transactions on Magnetics, MAG-9, (3), 485 (1973).) Thus, although the desired planar geometries have been achieved, this achievement requires significantly increased processing costs.

Summary of the Invention

Devices relying on magnetic properties and having planar geometries have been produced without increasing the number of processing steps necessary for device fabrication. This technique involves in the preferred embodiment the deposition of a resist material in a desired pattern on an electrically insulating layer. Etching of the exposed surface of the insulating layer is then performed. The exposed layer, and thus also the resist layer, is coated with the metal to be deposited such as an aluminum/copper alloy. The resist material is then lifted off giving the desired geometry. A second electrically insulating layer may then be optionally deposited before further processing of the device.

Brief Description of the Drawing

FIGS. 1 and 2 are schematic representations of previously disclosed fabrication processes which have been utilized in the production of devices relying on magnetic properties;

FIG. 3 is a schematic representation of a preferred embodiment of the subject inventive process; and

FIGS. 4 through 11 illustrate the practice of a preferred embodiment of the invention.

Detailed Description

For pedagogic purposes, the invention will be described in terms of the production of a magnetic bubble device. However, it should be understood that the subject invention is not limited to the production solely of such devices and is generally applicable to devices which require the fabrication of a planar geometry.

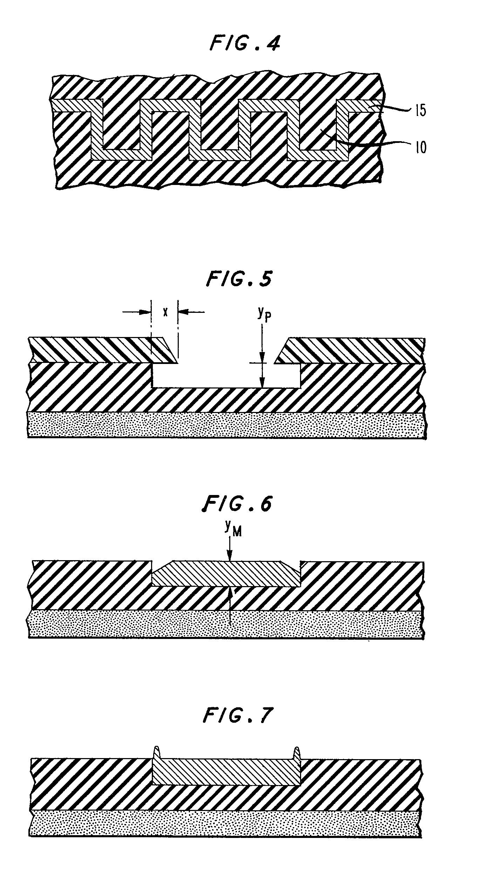

The subject process is performed on an electrically insulating layer, 16, in FIG. 3 (FIG. 3 illustrates the steps in the preferred embodiment of the invention) which is susceptible to etching. For example, in the preferred embodiment a silicon dioxide layer

4.                    0022580

typically deposited on the epilayer of a magnetic garnet is utilized. (See for example, S. L. Blank and J. W. Nielsen, Journal of Crystal Growth, 17, 302 (1972), and S. L. Blank et al, Journal of the Electrochemical Society, 123, 876 (1976), for conventional fabrication techniques involved in depositing garnet epilayers and D. C. Bullock, et al, IEEE Transactions on Magnetics, MAG-12, 654 (1976) for techniques used in the subsequent deposition of a silicon dioxide layer.) This insulating layer is primarily employed as an electrical insulator. The insulation required is between portions of the metallic pattern which are subsequently deposited. As noted, in many devices metallic patterns are deposited on a substrate in order to produce local effects such as nucleation in the substrate. Obviously, if an electrically conducting layer is used directly on the substrate, all portions of the subsequently deposited metallic pattern will be electrically continuous. Thus, if the underlying layer is not insulating, it is impossible to direct a single electrical signal to a specific portion of the metallic pattern, and thus, it is impossible to localize specific desired functions. The necessary electrical isolation provided by the insulator depends on the application desired. Typically, it is advantageous to limit current flow through the insulator to $1 \times 10^{-6}$ of that through the metal pattern. That is, as shown in FIG. 4, the current through the portion marked 10, which is the insulator, should be at least a factor of $10^{+6}$ less than the current through the electrical conductor, 15. For most patterns utilized in conventional devices, the cross-sectional area and length of the metal is approximately equal to that of the insulator. Therefore, generally to achieve this desired criterion, it is sufficient to chose an insulator whose resistivity is at least $10^{+6}$ times of the resistivity demonstrated by the particular metal utilized. Obviously, if there is a large difference between the width of the insulating layer between various portions of the metal pattern and the width of the metal pattern itself, appropriate corrections must be made to this general criterion. Most commonly recognized insulators satisfy this criterion. Typically, silicon dioxide is a convenient insulating material.

The insulating region described is also used as a method of reducing strain gradients in the underlying substrate. For example, in certain circumstances when metals are deposited and patterned directly on a garnet layer, strain gradients can arise from the patterned interruption of the inherent metallization strain. (See, for example, Dishman, et al, Journal of Applied Physics, 45, (9), 4076 (1974).) These strain gradients are directly transferred to the magnetic epilayer. The use of an intermediary layer reduces the strain gradients and, therefore, reduces any disadvantageous results which might occur. The necessity for this strain isolation will be further discussed in conjunction with the etching step.

A delineating material, 17 in FIG. 3, is then introduced as a mask onto the electrical insulating layer in a desired pattern. The pattern chosen should be the negative of the pattern desired for the metallic layer that is ultimately to be deposited. Typical of delineating materials are photoresists, for example, polymeric resists. The patterning of delineating material on an electrical insulating layer is well-known and adequately described in a variety of publications. (See, for example, Journal of the Electrochemical Society, 120, 140 (1973).) Once these resists are deposited in the desired pattern they are advantageously heated (generally to approximately 120 degrees C) to produce a rounding as indicated by 19 in FIG. 3. The rounding to be most advantageous should have a radius approximately equal to or greater than the thickness of the film. This rounding allows more complete filling of the etch pit produced in the subsequent etching step. If the expedient of rounding the delineating material edge is utilized, the thickness of the delineating material is not critical. Typically, delineating material of thicknesses between 0.5 and 1.5μm is utilized. Thinner material usually provides the better resolution. However, as a practical limit to insure continuity of the delineating material, a thickness less than 0.5μm is generally not desirable. If the material is thicker than 1.5μm resolution better than 1.5μm generally is not obtainable. If patterns having detail requiring resolution poorer than this resolution limit are acceptable, thicker layers are usable. However, for typical devices resolution better than 1.5μm is necessary to produce the desired pattern and, therefore, thicknesses of the delineating material less than 1.5μm, preferably less than 1μm, are generally necessary. If the expedient of rounding the edges is not utilized, the thickness of the delineating material is somewhat more significant. Without the rounding procedure, generally for resolutions better than 2μm, thicknesses less than 1μm should be utilized.

In the two steps following deposition of a delineating material, pits 21 in FIG. 3, are etched in the exposed area of the electrically insulating material and then the desired metal, 22 in FIG. 3, is deposited in these pits. The depth of the pits and the thickness of the metal ultimately deposited are to an extent interdependent. As previously mentioned, these pits are not necessarily etched entirely through the electrically insulating layer. Transfer of patterned strain to the magnetic garnet film is reduced when such pits do not completely penetrate the silicon dioxide layer thickness. However, the use of pits which do extend completely through this layer is possible. Generally, in a preferred embodiment, the electrically insulating layer is etched so that approximately between 1000Å and 4000Å (100 and 400 nanometers, respectively) of the layer remains. Although plasma etching techniques are found advantageous for silicon dioxide electrical insulating layers, other etching techniques

7.

0022580

that are compatible with silicon dioxide or other insulating layers are not precluded.

The metallic layer is then deposited after the etching of the insulating layer is completed. Conventional vacuum deposition techniques are utilized. For example, in the case of an aluminum/copper alloy, the material is deposited by electron beam evaporation. In the preferred embodiment, an alloy of 95.5 % aluminum and 4.5% copper, by weight, is deposited by this evaporation technique. The thickness of the metallic layer must be chosen so that it is possible to remove the delineating material in a subsequent processing step. Additionally, the thickness must be chosen so that an essentially planar geometry results. These two requirements are met by maintaining the appropriate ratio between $Y_p$, (see FIG. 5) the depth of the etched pit, and $Y_M$, (see FIG. 6) the thickness of the metallized layer. The appropriate criteria is that $4/3 \geq Y_M/Y_p \geq 1/2$. This insures that the surface of the metallized layer is sufficiently proximate to the level of the surface of the insulating electrical layer to produce a planar geometry as well as assure the subsequent removal of the delineating material. Deviations greater than those specified produce unacceptably non-planar features when the subsequent insulating electrical layer is deposited.

The undercut, i.e., the area denoted X in FIG. 5 also must be sufficient to allow the removal of the resist by an expedient method such as liftoff during subsequent processing steps. This criteria is satisfied when $3/2 \geq X/Y_p \geq 1/3$. When this relationship is adhered to, structures such as shown in FIG. 6 instead of those as shown in FIG. 7 are obtained.

The delineating material is then removed by an expedient technique, e.g., liftoff. For example, in the case of photolithographic resists a suitable solvent is utilized to cause the degradation of the resist film. As can be seen in FIG. 3, when the metal is deposited in the etched areas e.g. as metal portions 22, overlying metal film portions 30 are simultaneously deposited on the resist material. For typical metals such as aluminum or aluminum alloys, these overlying metal film portions 30 do not hinder the resist removal. However, caution should be taken that metals and resist combinations are not employed which prevent the removal of the resist material.

The results of this process is the planar geometry, 31, shown in FIG. 3. The entire structure may then be covered by a second layer of an electrically insulating material. In the preferred embodiment of production of a magnetic bubble device another metal layer may then be deposited on this second electrically insulating layer. This second metal layer is utilized as an expedient to produce propagation in the garnet epilayer. Permalloy patterns, (see Yamagishi, supra) or dual conductor patterns, (see A. H. Bobeck U. S. Patent 4,162,537, issued July 24, 1979, from U. S. patent application 914,959, filed June 12, 1978), are compatible with the subject technique. The following examples illustrate typical processing parameters used in employing the subject invention:

Example 1

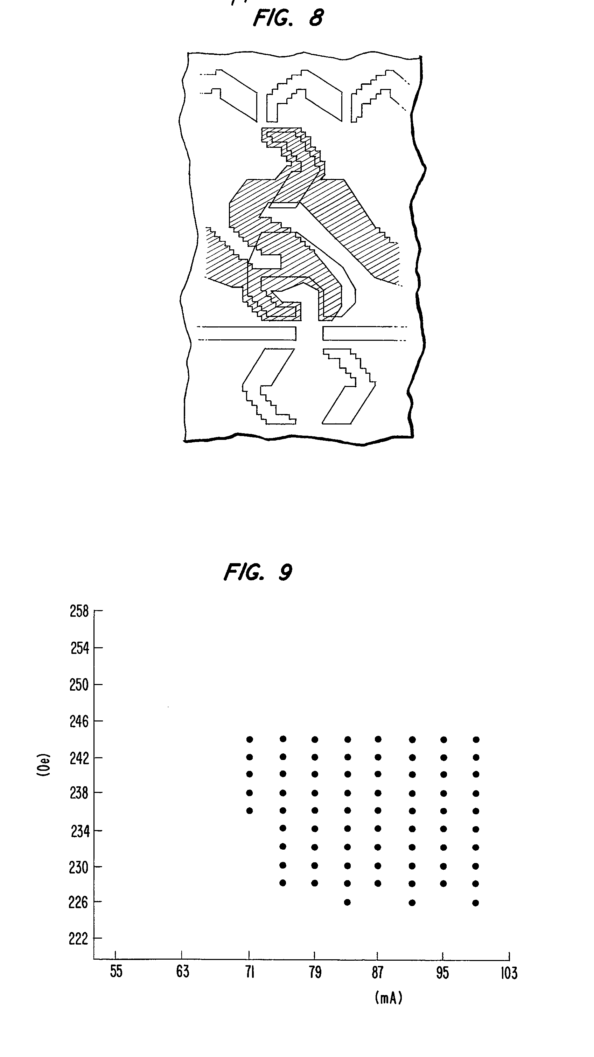

An epilayer having a composition of a nominal formula $Y_{1.2}Lu_5Sm_{0.4}Ca_{0.9}Ge_{0.9}Fe_{4.1}O_{12}$ described in Blank et al, Journal of Applied Physics, 50, 2155 (1979), and having a 5000$\overset{o}{A}$ (500 nanometers) thick Rf sputter deposited silicon dioxide cover layer was utilized. An Rf power of 1.2 w/cm$^2$ using 13.56 MHz excitation radiation was employed to deposit the $SiO_2$. The sputtering target was fused quartz. The silicon dioxide surface thus obtained was cleaned by brushing with a water detergent solution. A 7500$\overset{o}{A}$ (750 nanometers) thick layer of Shipley AZ1350B resist (a proprietary product of Shipley Corporation, Newton, Massachusetts which is a positive acting phenolic base resist) was uniformly spun coated onto the exposed face of the silicon dioxide layer. The resist was baked at 85 degrees C for one-half hour in an air oven. To produce a replicate function on this epilayer, the resist was exposed through a mask using nominal 4000Å (400 nanometers) radiation. The mask allowed exposure of all the shaded regions shown in FIG. 8. (The shaded regions of FIG. 8 indicate the pattern of aluminum/copper replicate function. The remaining structures shown in this figure are the overlying permalloy pattern.) The exposure was continued until it reached 80 m-Joule/$cm^2$. The exposed resist was spray developed using Shipley AZ developer (a proprietary product of Shipley Corporation, Newton, Massachusetts, which is primarily composed of an aqueous solution of sodium hydroxide and sodium silicate). The developed resist was rinsed in deionized water and spun dry.

The developed resist was then further dried by baking in an air oven at 100 degrees C for 20 minutes. The sample was placed vertically in the sample holder of a commercial plasma etching apparatus. The pressure was reduced below 1 Torr (1.3332 x $10^{-3}$ bar) in the sample chamber, air was introduced into the chamber, and a plasma struck by applying an appropriate voltage. The air pressure was adjusted to 1.2 Torr (1.6 x $10^{-3}$ bar) in the plasma region. This treatment with an $O_2$ containing gas was continued for 5 minutes at a power density of approximately 10 milliwatts/$cm^3$. (The $O_2$ plasma cleaned the organic residues from the exposed surface of the sample.) The chamber was then again evacuated to below 1 Torr (1.3332 x $10^{-3}$ bar). A mixture of 93% $CF_4$ and 7% $O_2$, by volume, was introduced into the chamber. Upon introduction of the etching gas, the plasma was struck by applying an appropriate voltage. The gas pressure was adjusted until the pressure in the plasma region was about 0.6 Torr. The etch was continued for 35 minutes at a power density level of approximately 17 milliwatts/$cm^3$.

This produced etch pits of approximately 3500$\overset{o}{A}$ (350 nanometers) depth and an undercutting of similar dimension. The samples were removed from the etching chamber and without removing the photoresists, the samples were then transferred to the sample holder of a conventional planetary evaporator. The target utilized in this evaporator was an alloy of 81% aluminum and 19% copper, by weight. An electron beam density sufficient to yield an evaporation rate of approximately 1000$\overset{o}{A}$/min. (100 nanometers/minute) was utilized. The evaporation was continued until a total aluminum alloy thickness of 3500$\overset{o}{A}$ (350 nanometers) was obtained. The alloy obtained on the etched silicon dioxide layer had a composition of 4.5% copper and 95.5% Al by weight. The samples were removed from the evaporator and were immersed in acetone that was heated to approximately 40 degrees C. The bath was ultrasonically agitated using a conventional low power agitator. This treatment effectively removed the resist and any metal overlaying the resist. The samples were removed from the bath and sprayed with acetone to remove any particulate matter. The samples were then plasma cleaned with $O_2$ as described previously. However, the cleaning gas was a mixture of 96% He and 4% $O_2$, by volume, at a pressure of 1 Torr (1.3332 x $10^{-3}$ bar) as measured in the plasma region.

The sample was then placed in a conventional diode sputtering system. Using the deposition conditions previously described, a silicon dioxide layer thickness of approximately 1000$\overset{o}{A}$ (100 nanometers) was sputtered onto the samples. After sputter deposition, the samples were cleaned by brush scrubbing with an aqueous detergent. Permalloy in the pattern indicated by the unshaded region in FIG. 8, was deposited onto the second silicon dioxide layer using a conventional electron beam evaporation, photolithography, and ion beam etching techniques.

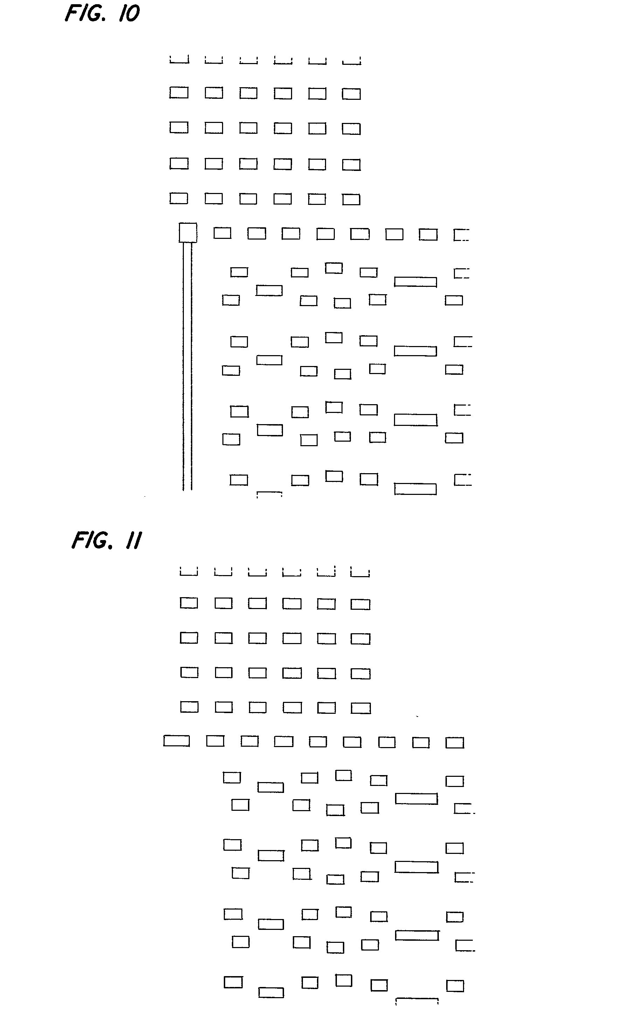

A drive field of approximately 60 Oe (4776 A/m) was applied to the device. Varying bias fields were imparted to the device and the current necessary at each bias level to produce bubble replication was measured. The results obtained are shown in FIG. 9. As can be seen, an excellent range of acceptable operation was achieved. By contrast, the replication function was inoperable over the same range of parameters when fabricated in a conventional non-planar structure.

Example 2

A garnet epilayer having a $2500\overset{o}{A}$ (250 nanometers) thick $SiO_2$ layer was utilized. This silicon dioxide layer was produced in a conventional CVD plasma reactor utilizing a sample temperature of 235 degrees C, a 50 KHz excitation at a power level of approximately 150 milliwatts/$cm^2$, and a plasma gas of 6% $SiH_4$ and 94% $N_2O$, by volume, composition. The procedure as described in Example 1 was utilized on this substrate except a resist thickness of $5000\overset{o}{A}$ (500 nanometers) was employed. The resist, after patterning was heated to a minimum temperature of approximately 120 degrees C for 15 minutes to flow the resist and produce rounded edges. The sample was cleaned and etched as described in Example 1 except a power density of 10 milliwatts/$cm^3$ was utilized with an etchant gas pressure in the plasma region of approximately 1 Torr ($1.3332 \times 10^{-3}$ bar). The etching was continued until the etch pit reached the underlying garnet epilayer. This etching procedure took approximately 6 minutes. The subsequent aluminum alloy deposition and metal lift-off procedure were as described in Example 1. The pattern of the initial aluminum alloy layer was as shown in FIG. 10. The second silicon dioxide layer was deposited by the plasma enhanced CVD method as described previously in this example. A thickness for the second $SiO_2$ layer of approximately $1500\overset{o}{A}$ (150 nanometers) was utilized. Conventional evaporation techniques, lithography and chemical etching procedures were utilized to fabricate the second aluminum alloy layer in the pattern shown in FIG. 11 onto this second silicon dioxide layer.  In both cases, the patterned aluminum alloy layers in FIG. 10 and FIG. 11 were perforated sheets, the holes being represented by the small rectangles in each figure.

Claims

1. A process for fabricating a device that relies on magnetic properties, especially useful for fabrication of magnetic bubble devices, comprising the steps of forming on an electrically insulating layer an electrically conducting layer in a desired pattern and optionally, depositing a second layer of electrically insulating material onto the patterned electrically conducting layer,

CHARACTERIZED BY

forming said pattern of the electrically conducting layer by

a) masking the electrically insulating layer with a delineating material such that exposed portions of the electrically insulating layer correspond with the desired pattern,

b) etching away, at least partially, the thickness of the exposed portions of the electrically insulating layer,

c) depositing a metal onto the etched electrically insulating layer in a thickness such that an essentially planar geometry is formed by the surface of the metal layer in the exposed portions of the electrically insulating layer and by the surface of the delineated portions of the insulating layer, and

d) removing the delineating material and any metal which may be upon the delineating material.

2. The process according to claim 1, CHARACTERIZED BY

depositing an aluminum alloy as the said electrically conducting layer.

3. The process according to claim 2, CHARACTERIZED BY

depositing the aluminum alloy containing 4.5% Cu, remainder Al, by weight.

4. The process according to claim 1, 2 or 3,

2.

0022580

CHARACTERIZED BY

utilizing $SiO_2$ as the said first electrically insulating layer.

5. The process according to any one of preceding claims 1-4,

CHARACTERIZED IN THAT,

whenever said device is a magnetic bubble device, depositing said second electrically insulating layer onto said electrically conducting layer and on the priorly delineated portions of the electrically insulating layer and depositing a second electrically conducting layer in a desired configuration on said second electrically insulating layer.

6. The process according to claim 5,

CHARACTERIZED BY

depositing a permalloy layer in a desired configuration as the said second electrically conducting layer.

7. The process according to claim 5 or 6,

CHARACTERIZED IN THAT

said second electrically conducting layer is formed into a pattern in a succession of steps similar to the formation of the pattern of the first-mentioned electrically conducting layer.

8. The process according to any one of the preceding claims 1-7,

CHARACTERIZED BY

etching said first electrically insulating layer by plasma etching.

FIG. 1

FIG. 2

FIG. 3

FIG. 4

FIG. 5

FIG. 6

FIG. 7

3/4
**FIG. 8**

**FIG. 9**

4/4

FIG. 10

FIG. 11

## DOCUMENTS CONSIDERED TO BE RELEVANT

| Category | Citation of document with indication, where appropriate, of relevant passages | Relevant to claim |
|---|---|---|
| X | IBM TECHNICAL DISCLOSURE BULLETIN, vol. 20, no. 11B, April 1978, pages 4805-4806 New York, U.S.A. G.A. BROOKS et al.: "Planar lift-off process"<br><br>* Pages 4805-4806 *<br><br>-- | 1,4,8 |
| X | FR - A - 2 337 429 (I.B.M.)<br>* Claims 1,8 *<br><br>-- | 1,4 |
| D | IEEE TRANSACTIONS ON MAGNETICS, vol. MAG-12, no. 6, November 1976, pages 618-621 D.K. ROSE: "Planar processing for magnetic bubble devices"<br><br>* Page 619; figures 1,2 *<br><br>-- | 2,3 |
| A | GB - A - 1 475 884 (THE POST OFFICE)<br>* Claims 1-14 *<br><br>---- | 1 |

**CLASSIFICATION OF THE APPLICATION (Int. Cl. 3)**

H 01 F 41/14

**TECHNICAL FIELDS SEARCHED (Int.Cl. 3)**

H 01 F 41/14
        10/06
G 21 C 19/08
H 01 L 21/90

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

The present search report has been drawn up for all claims

| Place of search | Date of completion of the search | Examiner |
|---|---|---|
| The Hague | 10-10-1980 | VAN DEN BULCKE |

EPO Form 1503.1  06.78